# EUROPÄISCHE PATENTSCHRIFT

(11) **EP 1 514 851 B1**
(45) Veröffentlichungstag und Bekanntmachung des Hinweises auf die Patenterteilung: **14.11.2007**
(21) Anmeldenummer: 04020355.6
(22) Anmeldetag: 27.08.2004
(51) Int. Cl.: C03C 17/22, C03C 17/245, C23C 14/58, C03C 17/00, C23C 14/08

(54) **Schutzschicht für einen Körper sowie Verfahren und Anordnung zur Herstellung von Schutzschichten**
Protective coating for a body as well as process and plant unit for preparing protective coatings
Revêtement de protection pour un corps, procédé et sytème pour sa préparation

(30) Priorität: 13.09.2003 DE 10342398
(43) Veröffentlichungstag der Anmeldung: 16.03.2005
(73) Patentinhaber: Schott AG, 55122 Mainz (DE)
(72) Erfinder: Klippe, Lutz, Dr., 65187 Wiesbaden (DE); Krause, Cora, Dr., 76835 Burrweiler (DE); Dzick, Jürgen, Dr., 30926 Seelze (DE)
(74) Vertreter: Blumbach - Zinngrebe

(56) Entgegenhaltungen:
- WO-A-02/46491
- US-A- 5 888 593
- US-A1- 2002 117 250
- TOMASZEWSKI H ET AL: "Yttria-stabilized zirconia thin films grown by reactive r.f. magnetron sputtering" 30. Oktober 1996 (1996-10-30), THIN SOLID FILMS, ELSEVIER-SEQUOIA S.A. LAUSANNE, CH, PAGE(S) 104-109 , XP004049478 ISSN: 0040-6090 * das ganze Dokument *
- TOMASZEWSKI H ET AL: "Yttria-stabilized zirconia thin films grown by r.f. magnetron sputtering from an oxide target" THIN SOLID FILMS, ELSEVIER-SEQUOIA S.A. LAUSANNE, CH, Bd. 293, Nr. 1-2, 30. Januar 1997 (1997-01-30), Seiten 67-74, XP004112512 ISSN: 0040-6090
- RUDDELL D E ET AL: "The effect of deposition parameters on the properties of yttria-stabilized zirconia thin films" PREPARATION AND CHARACTERIZATION, ELSEVIER SEQUOIA, NL, Bd. 445, Nr. 1, 23. Juli 2003 (2003-07-23), Seiten 14-19, XP004471443 ISSN: 0040-6090
- HOBEIN B ET AL: "DC Sputtering of yttria-stabilised zirconia films for solid oxide fuel cell applications" JOURNAL OF THE EUROPEAN CERAMIC SOCIETY, ELSEVIER SCIENCE PUBLISHERS, BARKING, ESSEX, GB, Bd. 21, Nr. 10-11, 2001, Seiten 1843-1846, XP004301783 ISSN: 0955-2219
- DENUL J ET AL: "Ion assisted deposition of biaxially aligned YSZ layers on metal tape" PHYSICA C, NORTH-HOLLAND PUBLISHING, AMSTERDAM, NL, Bd. 351, Nr. 1, 1. März 2001 (2001-03-01), Seiten 45-48, XP004230658 ISSN: 0921-4534

## Beschreibung

Die Erfindung bezieht sich auf eine Schutzschicht, insbesondere auf eine Hartstoffschicht mit hoher Kratzfestigkeit und Temperaturbeständigkeit, sowie ein Verfahren und eine Anordnung zur Herstellung von Schutzschichten.

Die Erfindung bezieht sich im speziellen auf eine Schutzschicht für Glaskeramikplatten sowie ein Verfahren und eine Vorrichtung zu deren Beschichtung, die vorzugsweise als Kochflächen in Kochfeldern dienen und auf zumindest einer Seite eine Schutzschicht mit einer gegenüber der unbeschichteten Glaskeramik erhöhten Kratzfestigkeit besitzen.

Moderne Kochfelder besitzen eine Glaskeramikplatte als Kochfläche, wobei die Glaskeramikplatte typischerweise plan ist, aber auch zwei oder dreidimensional verformt sein kann. Es sind sowohl Glaskeramikplatten druckschriftlich bekannt bzw. auf dem Markt, die undekoriert oder mit temperaturstabilen Farben, z.B. keramischen Farben, dekoriert sind. Die Kochfläche weist einzelne Kochzonen auf, die induktiv, mit elektrisch betriebenen Strahlungsheizkörpern, mit Gasstrahlungsheizelementen oder mit alternativen Heizsystemen (z.B. DHS von SCHOTT) beheizt werden.

Glaskeramikplatten haben typischerweise eine Mohshärte mit einem Härtegrad von 5 - 6, der vergleichbar dem von Stahl ist, aus dem typischerweise das Kochgeschirr hergestellt wird. Der alltägliche Gebrauch, d.h. Abstellen bzw. Verschieben des Kochgeschirres sowie Reinigen der Kochflächen mit abrasiven Reinigungsmitteln und Schwämmen bzw. mit einem Schaber, stellt eine hohe mechanische Belastung des Kochfeldes dar, die dazu führen kann, Gebrauchsspuren auf dem Kochfeld hervorzurufen.

Hinzu kommt, dass die Kochfläche in kaltem Zustand häufig als zusätzliche Abstellfläche Verwendung findet. Gerade hier besteht ein erhöhtes Risiko der Ausbildung von Oberflächenschädigungen beispielsweise durch rauhe Böden keramischer Gegenstände. Alle entstehenden Oberflächenschädigungen führen im Laufe der Zeit zur Ausbildung einer Verkratzung der Oberfläche, die in Abhängigkeit von der gewählten Beleuchtung mehr oder weniger stark für den Beobachter auffällig wird. Hinzu kommt, dass Schädigungen der Oberfläche Ansatzpunkte für Verschmutzungen bieten. Die leichte Reinigbarkeit der Oberfläche wird eingeschränkt, da die Abreinigung von Verschmutzungen aus diesen Schädigungen deutlich erschwert ist. Dieser Effekt ist unabhängig davon, ob das Kochfeld transparent, farbig oder transluzent ist.

Die Glaskeramikplatten der früheren Generation besaßen eine orangenhautähnliche typische Oberflächenstruktur. Obwohl auch diese Platten durch oben beschriebene Vorgänge verkratzt wurden, boten sie aufgrund der zusätzlichen Oberflächenstruktur eine relativ geringe Kratzerauffälligkeit. Die Oberflächen der Glaskeramikplatten sind jedoch im Laufe der Zeit glatter und glänzender geworden, was aus den vorgenannten Gründen zu einer verstärkten Kratzerauffälligkeit führt.

Die EP 0 716 270 B1 beschreibt eine Kochfläche aus Glaskeramik, auf deren Oberseite ein Dekor vorgesehen ist, die zum Vermeiden von Kratz- bzw. Gebrauchsspuren eine Schutzschicht in Form von Emailflüsse oder einer Silikatbeschichtung mit einer gegenüber der Glaskeramik erhöhten Kratzfestigkeit besitzt, wobei diese Schutzschicht die Glaskeramikkochfläche geschlossen bzw. möglichst geschlossen bedeckt, und auf diese Schutzschicht oder direkt auf die Glaskeramikoberfläche ein Dekor aufgedruckt ist. Bevorzugt ist die Schutzschicht aus einem dunklen Material ausgebildet. Durch diese Schutzschicht wird zwar die mechanische Belastbarkeit der Glaskeramikkochflächen grundsätzlich erhöht, so dass im Gebrauch der Kochfläche eine verminderte Kratzerauffälligkeit gegenüber einer ungeschützten Kochfläche auftritt, jedoch bieten die allein in der EP Schrift offenbarten Emailflüsse- bzw. Silikatschutzschichten noch keinen optimalen mechanischen Langzeitschutz. Nachteilig ist nämlich, dass die Schutzschicht selbst ein Dekor darstellt, das mittels Siebdruck aufgebracht wird. Diese Dekorfarben basieren in der Regel auf den gleichen Flüssen wie die zur optischen Gestaltung verwendeten Dekorfarben. Hinsichtlich Abrieb unterliegen sie damit gleichen Restriktionen. Die minimale Abmessung derartiger Dekore beträgt in der Größenordnung 0,5 mm, was auf jeden Fall optisch auffällig ist und somit designerisch störend ist, insbesondere wenn Gläser oder Glaskeramiken mit glatten Oberflächen gewünscht sind.

Ferner lassen die Ausführungen keinerlei Rückschluss darauf zu, inwieweit die vorgestellte Lösung mit den verwendeten Heizersystemen kompatibel ist. Gerade die Verwendung von bevorzugt dunklen Materialien als Schutzschicht für Glaskeramiken mit hoher IR-Transparenz und Strahlungsheizkörpern wird zu einer Beschränkung der gewollten IR-Transparenz und damit zu Einbußen hinsichtlich der Ankochperformance führen.

In der DE 100 00 663 A1 wird ein Verfahren und die zugehörige Vorrichtung beschrieben, mit denen ein optisch transparenter Körper mit einer Kratzschutzschicht aus Al₂O₃ ganzflächig mittels eines modifizierten PICVD Verfahrens versehen wird, derart, dass sich eine Hartstoffschicht ausbildet, da es sich gezeigt hat, dass mit den bekannten Verfahren keine ausreichend harte, dichte, kratzfeste sowie temperaturbeständige Schicht, insbesondere aus Aluminiumoxid, zu erzeugen ist. Nachteilig ist der große Verfahrensaufwand, insbesondere wenn großflächige Beschichtungen homogen aufgebracht werden müssen. Bisher sind Inhomogenitäten nicht vermeidbar, was zudem das optische Erscheinungsbild nachhaltig stört.

Ferner beschreibt WO 96/31995 eine induktiv beheizte Glas- oder Glaskeramikkochfläche mit integrierten Spulen, auf der eine Hartstoffschicht aus Al₂O₃ mittels der Technik des Plasmasprühens in einer Schichtdicke zwischen 50 und 200 µm aufgebracht ist. Nachteilig ist hierbei, dass derart dicke Schichten sehr rauh sind und damit die Gebrauchseigenschaften, wie Topfabrieb, Handabrieb sowie das Reinigungsverhalten nachteilig beeinflusst werden. Weiterhin ändert sich das Erscheinungsbild der Kochflächen mit einer solchen Schicht gänzlich. Die Oberfläche erscheint matt und grau.

Durch die DE 42 01 914 A1 (= US 5,594,231) ist es ferner bekannt, Abtastfenster aus Glas oder Glaskeramik von in Kassen von Supermärkten und anderen Verbrauchermärkten installierten Abtastsystemen zum Erfassen von auf den Warenverpackungen aufgebrachten Strichkodes, oberseitig mit einer lichtdurchlässigen Hartmaterial-Schicht, auf der wiederum eine lichtdurchlässige gleitfähige Beschichtung aufgebracht ist, zu versehen, um dieses Abtastfenster verschleißfester zu machen. Als Materialien für die Hartstoffschicht werden u.a. Metalloxide wie Al₂O₃, ZrO₂, SnO₂, Y₂O₃ genannt. Als besonders geeignet wird amorph abgeschiedenes Aluminiumoxid genannt. Gerade die amorphe Abscheidung des Metalloxides begünstigt hier die gewünschten besseren Härte- und Gleiteigenschaften der Schutzschicht. Die hier beschriebenen Hartstoffschichten sind für Anwendungen im Raumtemperaturbereich geeignet, verändern jedoch ihre Eigenschaften bei hohen Temperaturen, wie sie beispielsweise bei Kochflächen üblich sind, was sie für Verwendung bei hohen Temperaturen ungeeignet macht. Eine Schutzschicht für Kochflächen erfordert Materialien, die bis zu 800° C temperaturbeständig sind und die die hohen zwischen der Glaskeramik und Schutzschicht auftretenden thermo-mechanischen Spannungen auszuhalten vermögen.

Durch die DE 201 06 167 U1 ist ein Kochfeld mit einer Glaskeramikplatte als Kochfläche bekannt geworden, die mit einer transparenten Kratzschutzschicht versehen ist, die u.a. durch eine Hartstoffschicht gebildet werden kann. Als Materialien für diese transparente Schicht werden u.a. Metalloxide wie Aluminiumoxid, Zirkonoxid, Yttriumoxid, Zinnoxid, Indiumoxid und Kombinationen daraus genannt. Das Abscheiden der Materialien kann nach dieser Schrift z.B. durch die SOL GEL-Technik, die CVD-Verfahren, insbesondere durch das PICVD Verfahren und durch Sputtern erfolgen.

Mit den bekannten Verfahren zur Herstellung von Hartstoffschichten wie sie beispielsweise in den o.g.

Schriften DE 42 01 914 A1 und DE 201 06 167 U1 beschrieben sind, werden die Schichten typischerweise amorph oder in teilkristalliner Struktur abgeschieden. Derartige Schichten können bei längerem Gebrauch in den Heißbereichen bzw. im Fall maximaler thermischer Belastung nachteilige Veränderungen erfahren. So können sich in diesen Bereichen die Schichten durch thermisch induzierte Kompaktierung verfärben bzw. durch Kristallisation eintrüben, mit der Folge, dass die Heißbereiche optisch auffällig werden. Ferner kann es zu einer Aufrauung im Bereich von 1 bis 1000 nm kommen. Die Aufrauung selbst kann bereits eine optische Auffälligkeit bewirken, wobei die entstehenden Vertiefungen zusätzlich zu einer erschwerten Reinigung führen. Die Kristallisationsproblematik in den Heißbereichen verschärft ein mechanisches Versagen der Kratzschutzschicht. Bei der Kristallisation ändert sich der Aufbau der Schicht, so dass Risse in der Schicht entstehen. Durch den Verlust des lateralen Zusammenhalts bietet die Schicht keinen besonderen Kratzschutz mehr.

Um beispielsweise Zirkonoxid eine höhere Temperaturbeständigkeit zu verleihen, ist es bekannt (G.Wehl et al., Proc. CVD-VII, 536 (1979)) diesem sogenannte Stabilisatoren aus Yttriumoxid, Magnesiumoxid oder Calziumoxid zuzufügen. Jedoch hat eine solche Schicht, hergestellt mit den bekannten Verfahren, eine geringe Dichte, so dass eine solche Schicht porös ist.
Zirkonoxid-Hartstoffschichten sind auch aus den Veröffentlichungen
H. TOMASZEWSKI ET AL: "Yttria-stabilized zirconia thin films grown by reactive r.f. magnetron sputtering", THIN SOLID FILMS 287 (1996) 104-109,
H. TOMASZEWSKI ET AL: "Yttria-stabilized zirconia thin films grown by r.f. magnetron sputtering from an oxide target", THIN SOLID FILMS 293 (1997) 67-74,
D. E. RUDDELL ET AL: "The effect of deposition parameters on the properties of yttria-stabilized zirconia thin films", THIN SOLID FILMS 45 (2003) 14-19,
B. HOBEIN ET AL: "DC Sputtering of yttria-stabilised zirconia films for solid oxide fuel cell applications", JOURNAL OF THE EUROPEAN CERAMIC SOCIETY 21 (2001) 1843-1846 und
DENUL ET AL: "Ion assisted deposition of biaxially aligned YSZ layers on metal tape", PHYSICA C 351 (2001) 45-48,
bekannt. Als Substrate wurden in den Veröffentlichungen unter anderem Glas, Alumimiumoxid und Saphir, Silizium, Metalle, wie Aluminium oder Eisen-Chrom-Legierungen, Nickeloxid, sowie verschiedene Kunststoffe. Diesen Substraten ist gemeinsam, daß sie verglichen mit der Glaskeramik eines Kochfelds wesentlich höhere Temperaturausdehnungskoeffizienten aufweisen.

Das in der US 4 920 014 beschriebene Verfahren zur Herstellung einer solchen Schicht aus stabilisierten Zirkonoxid versucht dieses Problem dadurch zu lösen, das mittels des CVD Verfahrens und genau eingestellter Verfahrensparameter wie Temperatur des Substrates, Zeitpunkt und Dauer der Zuführung der Reaktionssubstanzen etc. die Schicht so abgeschieden wird, dass sie nur noch eine oder zwei parallel zur Substratoberfläche orientierte Kristallebenen aufweist. Abgesehen von einem sehr hohen Verfahrensaufwand, weisen derart kristalline Schichten noch immer eine raue Oberfläche auf.

Aus dem Anwendungsbereich der Turbinentechnik ist bekannt, dass säulenförmig gewachsene Schichten eine besonders hohe Widerstandsfähigkeit gegenüber schnellen thermischen Wechsellasten besitzen. So beschreibt die US 4 321 311 die Verwendung einer kolumnar gewachsenen keramischen Schicht als thermischen Schutz für metallische Komponenten des Turbinenbaus. Die hierin beschriebenen Schichten haben jedoch aufgrund ihrer groben kristallinen Strukturen eine große Rauhigkeit bzw. Porosität.

Raue und poröse Oberflächen verschmutzen schnell und sind schwer zu reinigen. Sie sind außerdem optisch nicht klar transparent, sondern stark streuend und für Anwendungen mit optisch ansprechenden Oberflächen nicht geeignet.

Bei anderen optisch transparenten Körpern aus Glas oder Glaskeramik, die hohen Einsatztemperaturen ausgesetzt sind, z.B. Kaminsichtscheiben, Backofenscheiben für Pyrolyseherde etc., sind die Kratzschutzprobleme ähnlich gelagert wie bei Kochflächen.

Der Erfindung liegt die Aufgabe zugrunde, die Schutzschicht eines Körpers derart auszubilden, dass sie kratz- und verschleißfest ist, bei thermischen Belastungen strukturstabil bleibt und sich optisch nicht verändert sowie eine dauerhaft glatte und optisch ansprechende Oberfläche aufweist.

Die Lösung dieser Aufgabe gelingt mit einem Glaskeramik-Kochfeld mit einer Schutzschicht gemäß den Ansprüchen 1 bis 15, einem Verfahren gemäß den Ansprüchen 16 bis 34 und einer Verwendung einer Vorrichtung gemäß den Ansprüchen 35 bis 41.

Die erfindungsgemäße Schutzschicht eines Körpers weist mindestens eine Hartstoffschicht aus einem Metalloxid und/oder Metallnitrid und/oder Metallcarbid und/oder Metalloxonitrid und/oder Metallcarbonitrid und/oder Metalloxocarbonitrid auf, wobei mindestens eine dieser Hartstoffschichten eine morphologisch dichte Kolumnenstruktur besitzt.

Dabei ist es vorteilhaft, wenn diese dichten Kolumnenstrukturen als kristalline Säulenstrukturen mit mindestens einem Anteil von 50 %, vorzugsweise mit einem Anteil von mehr als 80 % in der Schicht ausgebildet sind. Durch diese Schichtmorphologie wird die Schicht besonders unempfindlich gegenüber mechanischen und thermischen Belastungen.

Hartstoffschichten aus Metalloxid und/oder Metallnitrid und/oder Metallcarbid und/oder Metalloxonitrid und/oder Metallcarbonitrid und/oder Metalloxocarbonitrid haben in Abhängigkeit von den Verfahrensbedingungen unterschiedlichste Schichtmorphologien und Eigenschaften. Durch die Einstellung von Prozessbedingungen, die ein kolumnares, vorzugsweise kolumnares kristallines Aufwachsen der Schicht in engen Säulenstrukturen ermöglichen, erhalten diese Hartstoffschichten eine dichte, glatte und optisch ansprechende Oberfläche und sind strukturstabil bei mechanischen und thermischen Belastungen.

Als kristallin bezeichnet man generell den Zustand von Festkörpern mit Anordnung ihrer Teilchen in einem dreidimensionalen Raumgitter bei ausgeprägter Fernordnung. Der kristalline Körper, hier die Hartstoffschicht, kann dabei aus vielen kleinen, unregelmäßig gelagerten Kristalliten bestehen oder die Gitterstruktur kann sich durch die ganze Schicht fortsetzen. Die sich bei der Schicht ausbildenden Kolumnen sind dicht nebeneinander liegende Säulenstrukturen, die sich überwiegend senkrecht zum Substrat ausbilden. Die Kristalle weisen vorrangig Orientierungen auf, die bei kolumnaren Wachstum geringe Tendenzen zur Verbreiterung zeigen.

Um eine möglichst geringe Porosität der Schutzschicht und damit auch eine möglichst geringe, reinigungsfreundliche Rauheit ihrer Oberfläche zu erzielen, ist die Schicht vorzugsweise so ausgebildet, dass die laterale Ausdehnung der Kolumnen kleiner als 1 µm ist. In einer besonders vorteilhaften Ausgestaltung ist die laterale Ausdehnung der Kolumnen kleiner als 200 nm. Die dicht gepackten Säulenstrukturen ermöglichen es außerdem, eine weitgehend unbehinderte optische Transmission zu erreichen und störende Effekte durch Lichtstreuung zu vermeiden.

Als besonders geeignet für transparente erfindungsgemäße Schutzschichten erweisen sich dabei Hartstoffschichten aus Siliziumnitrid oder Metalloxiden in temperaturstabilen Kristallphasen.

Es wurde gefunden, dass erfindungsgemäße Schichten, insbesondere aus Zirkonoxid oder Mischschichten auf Zirkonoxid-Basis, vor allem für transparente, optisch besonders ansprechende und in hohem Maße temperaturstabile Schutzschichten geeignet sind. Durch eine geeignete Abscheideprozedur kann eine besonders thermisch stabile, dichte kristalline Säulenstruktur erzeugt werden, die außerdem in hohem Maße kratzfest ist. Vorteilhaft ist hierbei, dass die Zirkonoxid-Schichten durch Zugabe von anderen Metalloxiden wie Yttriumoxid, Calziumoxid, Magnesiumoxid, Tantaloxid, Nioboxid, Scandiumoxid, Titanoxid oder einem Oxid aus der Gruppe der Lanthanioid-Oxide, wie z.B. Lanthanoxid oder Ceriumoxid sowie Kombinationen daraus, insbesondere jedoch durch Zugabe von 0,5 bis 50 mol% Y₂O₃, vorteilhaft durch Zugabe von 0,5 bis 10 mol% Y₂O₃ und besonders optimal durch Zugabe von 4 mol% Y₂O₃, in einer Hochtemperatur-Kristallphase derart stabilisiert werden können, dass sie wenigstens in dem für Kochsysteme relevanten Temperaturbereich (bis max. 800° C) keine temperaturabhängigen strukturellen Änderungen erfahren.

Die erfindungsgemäße Schutzschicht kann zu den bisher beschriebenen Hartstoffschichten noch eine oder weitere Hartstoffschichten enthalten. In welcher Reihenfolge, Anzahl und mit welchen Materialien diese ausgebildet werden, hängt im wesentlichen von den noch weiter gewünschten optischen und/oder mechanischen Anforderungen an die Schutzschicht ab.

Die erfindungsgemäßen Schutzschichten sind zur Beschichtung unterschiedlichster Körper, die vor allem eine hohe Kratzfestigkeit und Temperaturbeständigkeit aufweisen müssen, geeignet. Weiterhin ermöglichen sie ein ansprechendes optisches Erscheinungsbild und je nach Schichtmaterial auch Transparenz. Sie sind besonders geeignet als Schutzschichten für Glas, Glaskeramik oder Körper aus anderen nichtmetallischen kristallinen Materialien, aber darauf nicht beschränkt.

Besonders vorteilhaft eignet sich die Schutzschicht für die Beschichtung von Glaskeramikkochflächen. Hier stehen Anforderungen von hoher Kratzfestigkeit, Temperaturbeständigkeit und einem optisch ansprechenden Erscheinungsbild im Vordergrund, welche mit der erfindungsgemäßen Beschichtung erfüllbar sind.

Bei transparenten Schutzschichten können die Glaskeramikkochflächen oder andere zu beschichtende Körper unterhalb oder innerhalb der Schutzschicht zusätzlich dekoriert sein. Nichttransparente aber auch transparente Schutzschichten können auf der Schutzschicht zusätzlich dekoriert sein.

Das erfindungsgemäße Verfahren zum Beschichten eines Körpers mit einer erfindungsgemäßen Schutzschicht umfasst im wesentlichen das Bereitstellen des Körpers und der Schichtstoffe in einem Vakuumsystem und das Beschichten des Körpers mittels eines reaktiven physikalischen Aufdampfprozesses, wobei Schichtstoffen in atomaren Abmessungen erzeugt und zusätzlich energetisch angereichert werden, so dass sich überwiegend morphologisch dichte Säulenstrukturen, vorzugsweise kristalline Säulenstrukturen beim Aufwuchs der Schicht bilden.

Ein weiteres erfindungsgemäßes Verfahren zum Beschichten eines Körpers aus Glas, Glaskeramik oder einem anderen, nichtmetallischen kristallinen Material, vorzugsweise zum Beschichten einer Kochfläche, mit einer erfindungsgemäßen Schutzschicht umfasst im wesentlichen das Überführen des Körpers in ein Vakuumsystem unmittelbar nach seiner Herstellung und das Bereitstellen der Schichtstoffe sowie das Beschichten des Körpers mittels eines reaktiven physikalischen Aufdampfprozesses, wobei Schichtstoffen in atomaren Abmessungen erzeugt und zusätzlich energetisch angereichert werden, so dass sich überwiegend morphologisch dichte Säulenstrukturen, vorzugsweise kristalline Säulenstrukturen beim Aufwuchs der Schicht bilden.

Das Aufbringen der Schichten durch ionenstrahlunterstütztes Ionenstrahlsputtern führt zu besonders hohen Energieeinträgen. Diese Methode bietet die beste Möglichkeit, um die Morphologie bzw. Kristallstruktur der Schicht durch gezielte Einstellung der Ionen-Energie und Intensität des Ionenstrahls zu definieren. Die Energie der Ionen des unterstützenden Ionenstrahls liegt dabei zwischen 1 bis 2500 eV, bevorzugt zwischen 1 bis 800 eV, und besonders bevorzugt zwischen 20 bis 450 eV. Die Ionen-Energie und die Intensität des unterstützenden Ionenstrahls muss in jedem Fall so eingestellt werden, dass die Auftragsrate der Schichtstoffe größer bleibt als die Abtragsrate der Schichtstoffe durch die zusätzliche Ionenquelle. Die Ionenstrahlunterstützung kann auch gegebenenfalls zeitweilig unterbrochen werden.

Die Abscheidung der Schichten ist nicht auf Ionenstrahlsputtern beschränkt. Grundsätzlich sind alle Sputtertechniken einsetzbar. In Abhängigkeit von der gewählten Technik bestehen unterschiedliche Möglichkeiten, einen Ionenbeschuss der aufwachsenden Schicht zu realisieren. Unter Beachtung der vielfältigen Einstellmöglichkeiten hinsichtlich der Intensität und der Wahl der Ionen (Edelgase, Sauerstoff, Stickstoff etc.) und der geometrischen Anordnung der Ionenquellen in Bezug auf das zu beschichtende Substrat, lassen sich für den Fachmann diesbezüglich Einstellungen finden, mit denen erfindungsgemäße Schichten herstellbar sind. In Prozessen, die Magnetronquellen einsetzen, gelingt eine Herstellung erfindungsgemäßer Schichten beispielsweise durch den Einsatz eines sogenannten "unbalanced Magnetron", eines gepulsten Magnetrons, einer Mittelfrequenz-Magnetronquelle mit sehr hohen Wechselfrequenzen oder durch Anlegen einer negativen Bias-Spannung an das Substrat. In diesen Prozessen wird der benötigte Ionenbeschuss der aufwachsenden Schicht durch Extraktion der Ionen aus dem Plasma der Materialquelle realisiert. Weitere Maßnahmen, mit denen dies erreicht werden kann, sind Stand der technik. Es ist zusätzlich möglich, verschiedene Maßnahmen derart zu kombinieren, dass ein besonders starker Ionenbeschuss erreicht wird.

Außerdem kann es vorteilhaft sein, vorzugsweise bei Metalloxidschichten, insbesondere bei stabilisierten Zirkonoxid-Schichten, mindestens ein zusätzliches Gas, beispielsweise Stickstoff, zur Optimierung der Abtragsrate bei der Erzeugung der Schichtstoffe bzw. zur Optimierung des Ionisationsgrades des Reaktivgases und/oder Sauerstoff zur Optimierung der Oxidation der Schicht in das Vakuumsystem einzuspeisen.

Zusätzlich können oxidische Schichten, die verfahrensbedingt nicht vollständig oxidiert hergestellt wurden und deshalb eine gestörte Kristallstruktur aufweisen, durch eine nachträgliche thermische Behandlung in oxidierender Atmosphäre aufoxidiert und damit ausgeheilt werden. Die Temperaturbehandlung kann in einem Rezipienten erfolgen, in dem der beschichtete Körper auf Temperaturen bis 800°C, bevorzugt auf 400°C bis 700°C erwärmt werden kann.

Zusätzlich kann in den Rezipienten Sauerstoff eingelassen werden. Bevorzugt liegen die Sauerstoffpartialdrücke, die eingestellt werden, zwischen 10⁻² und 1000 mbar. Die Dauer der Temperaturbehandlung sollte zwischen 1 Minute und 10 Stunden, bevorzugt zwischen 10 bis 60 Minuten liegen.

In Abhängigkeit vom Zeitpunkt in der gesamten Produktionskette kann es erforderlich sein, die zu beschichtenden Körper vor der Beschichtung einer Reinigung zu unterziehen. Eine Reinigung wird dann nicht notwendig erfolgen, wenn die Beschichtung unmittelbar an den letzten Heißschritt in der Herstellung eines Glas- bzw. Glaskeramikkörpers anschließt, da zu diesem Punkt sauberste Oberflächen vorliegen.

Die Reinigung der zu beschichtenden Gegenstände kann durch Verwendung mindestens eines geeigneten Reinigungsbades mit abschließender Trocknung erfolgen, um Verschmutzungen von der zu beschichtenden Oberfläche zu entfernen. In Abhängigkeit von den auftretenden Verschmutzungen kann es erforderlich sein, mehr als ein Reinigungsbad einzusetzen und zusätzliche Reinigungseffekte durch eine Beheizung und/oder Ultraschallanregung anzuwenden.

Es besteht weiterhin die Möglichkeit, die Reinigung in einer Vakuumkammer durch eine Plasmabehandlung mit Ionen, deren Energie vorzugsweise im Bereich von 1 bis 2500 eV, bevorzugt von 50 bis 1600 eV, und besonders bevorzugt von 100 bis 500 eV liegt, durchzuführen. Mögliche Ausführungsformen dafür sind beispielsweise der Beschuss des Substrates mit Ionen aus einer Ionenquelle oder das "Baden" der Probe im Plasma einer Glimmentladung. Dadurch wird eine besonders intensive Reinigung der Oberfläche von Fremdatomen und Adsorbaten erreicht. Sinnvolle Reinigungszeiten liegen zwischen einigen Sekunden bis zu einigen Minuten.

Außerdem ist es vorteilhaft, die Oberfläche des zu beschichtenden Körpers zu aktivieren. Die Aktivierung kann ebenfalls in einer Vakuumkammer durch eine Plasmabehandlung der Oberfläche, wie vor beschrieben, erfolgen. Die Reinigung und Aktivierung können dann gegebenenfalls in einem Prozessschritt erfolgen.

Vor Beginn und während der Beschichtung kann der zu beschichtende Körper in der Vakuumkammer auf die Prozesstemperatur erwärmt werden, beispielsweise durch geeignete Heizelemente in der Vakuumkammer. Die Körpertemperatur kann zu Prozessbeginn zwischen Raumtemperatur und 800 °C gewählt werden, bevorzugt zwischen 50°C und 550°C, besonders bevorzugt zwischen 100°C und 350°C.

Weiterhin kann es erwünscht sein, eine besonders hohe Oberflächengüte des beschichteten Körpers zu erzielen. Dazu kann in einem oder mehreren Polierschritten, die dazu geeignet sind, die geringe verbleibende Oberflächenrauhigkeit bis zu einem Rₐ-Wert von 1 nm zu verbessern, die Oberfläche nochmals nachgearbeitet werden.

Die Beschichtung eines Körpers aus Glas, Glaskeramik oder einem anderen nichtmetallischen kristallinen Material, insbesondere einer Glaskeramik-Kochplatte, mit einer Schutzschicht, insbesondere mit einer erfindungsgemäßen Schutzschicht, gelingt erfindungsgemäß mit einer Beschichtungsanlage und einer mit ihr über eine Eingangsschleuse (2.2) und Substratübergabestation (2.1) direkt verbundenen Herstellungsanlage (1), in der der zu beschichtende Körper unmittelbar vorher hergestellt wurde. Die Beschichtungsanlage umfasst mindestens eine Beschichtungskammer (4.1), die eine Vakuumkammer ist, wobei diese ein Target (14) mit dem Schichtausgangsmaterial, eine Anregungsquelle zur Erzeugung von Schichtausgangsmaterialien in atomaren Abmessungen, eine auf das Substrat gerichtete, unterstützende Ionenstrahlquelle (12), mindestens ein Prozessgas-Einlassventil (15) zur Zufuhr von Prozessgasen in die Vakuumkammer sowie Shutter (7) als verschließbare Öffnungen zur Zu- und Abfuhr des zu beschichtenden Substrates (8) enthält.

Die Anregungsquelle kann eine Ionenstrahl-Anregungsquelle (13) oder eine Magnetronsputterquelle sein.

In einer vorteilhaften Ausführung weist die Beschichtungsanlage eine Reinigungs-/Aktivierungskammer (3) auf, wobei diese eine Vakuumkammer ist und mindestens eine Reinigungs-/Aktivierungs-Ionenstrahlquelle (11) zur Reinigung und/oder Aktivierung des Substrates (8) aufweist, zwischen der Eingangsschleuse (2.2) und der Beschichtungskammer (4.1) angeordnet ist und über Shutter (7) mit diesen verbunden ist.

Zur Herstellung von Schutzschichten mit mehreren Einzelschichten aus unterschiedlichen Schichtausgangsmaterialien ist es möglich, entweder das Target in der Beschichtungskammer auszutauschen oder aber entsprechend weitere Beschichtungskammern (4.n) anzuordnen. Alternativ können diese Beschichtungskammern (4.n) auch mit gleichen Schichtausgangsmaterialien belegt sein, um so mehrere Substrate gleichzeitig zu beschichten und die Durchsatzrate zu steigern.

Zur weiteren Optimierung von Metalloxidschichten, kann es vorteilhaft sein, diese in einer Sauerstoffatmosphäre nachzubehandeln. Dazu weist die Beschichtungsanlage eine Nachbehandlungskammer (5) auf, wobei diese ebenfalls eine Vakuumkammer ist und mindestens ein Sauerstoff-Zufuhrventil (16) sowie Heizelemente (9) enthält und über Shutter (7) mit der Beschichtungskammer (4.1) bzw. einer weiteren Beschichtungskammer (4.n) verbunden ist.

Vorzugsweise enthalten die Beschichtungskammern (4.1, 4.n) und die Reinigungs-/Aktivierungskammer (3) Heizelemente (9) zur Aufheizung des Substrates (8) und Realisierung eines optimalen Heizkonzeptes während der Beschichtung des Substrats (8).

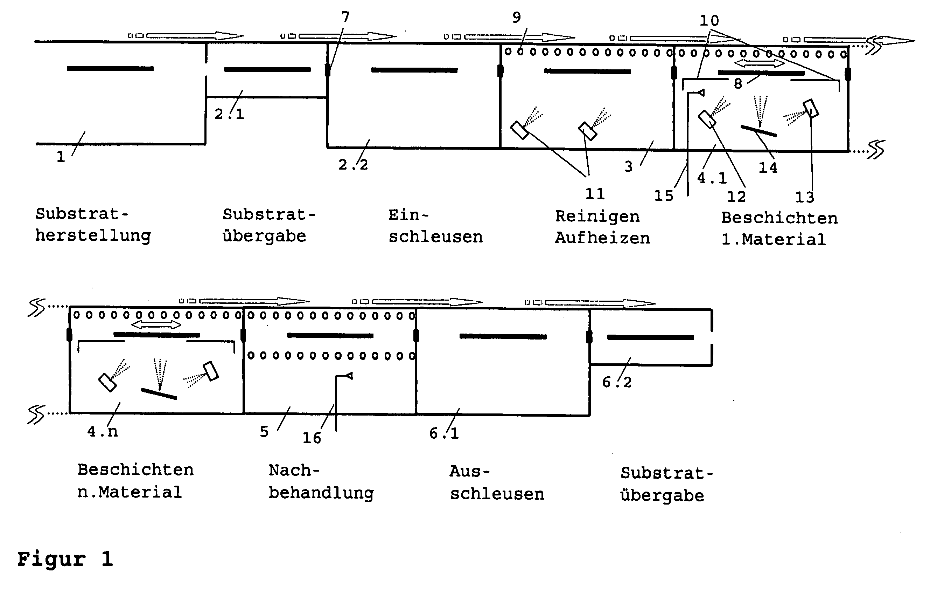

Nach der Beschichtung des Substrates (8) und gegebenenfalls Nachbehandlung der Schicht, wird das Substrat (8) über eine Ausgangsschleuse (6.1) und Substratausgabeeinheit (6.2) aus der Beschichtungsanlage geführt. Die Ausgangsschleuse (6.1) ist über einen Shutter (7) mit der letzten Vakuumkammer in der Bearbeitungskette verbunden. Die Erfindung soll im weiteren an Hand eines Ausführungsbeispieles näher erläutert werden. Dazu zeigt
- Figur 1:: eine Ionenstrahlsputteranlage mit einer Ionenstrahlunterstützung
Mit einer in Figur 1 gezeigten Ionenstrahlsputteranlage, die mit einem unterstützendem Ionenstrahl arbeitet, können Schutzschichten, insbesondere transparente, optisch ansprechende, struktur- und temperaturstabile Kratzschutzschichten, beispielsweise aus stabilisiertem Zirkonoxid, auf eine Glaskeramikkochplatte aufgebracht werden.

### Substratübergabe:

Das Substrat (8), beispielsweise eine CERAN-Platte für Kochfelder mit einer Abmessung von 60 cm * 60 cm, wird unmittelbar nach seiner Herstellung, im Anschluss an den letzten Heißschritt der Keramisierung, aus der Herstellungsanlage (1) in die Beschichtungsanlage überführt. Die Beschichtungsanlage ist eine vertikale Anlage, die eine randlose Beschichtung der Substrate (8) ermöglicht. Die Substrate (8) werden einzeln in die Beschichtungsanlage überführt.

Nach Überführung eines Substrates (8) in die Substratübergabestation (2.1) wird diese geschlossen und ein Druck von < 1 mbar eingestellt. Anschließend wird das Substrat (8) über einen Shutter (7) in die Eingangsschleuse (2.2) überführt. Die Eingangsschleuse (2.2) wird evakuiert, so dass in dieser ein Druck von < 10⁻² mbar eingestellt wird. Generell erfolgt die weitere Übergabe des Substrates (8) von einer Prozesseinheit zur nächsten innerhalb der Sputteranlage über die Shutter (7). Das Substrat wird anschließend in die Reinigungs-/Aktivierungskammer (3) überführt.

### Substratreinigung und -aktivierung:

Die Reinigungs-/und Aktivierungskammer (3) ist ebenfalls eine Vakuumkammer, in der sich Heizelemente (9) zur Aufheizung des Substrates (8) und Reinigungs-/Aktivierungs-Ionenstrahlquellen (11) befinden.

Eine Reinigung muss nicht notwendig erfolgen, da die Beschichtung unmittelbar an den letzten Heißschritt in der Herstellung anschließt. Gegebenenfalls kann die Reinigung des Substrates (8) in einem Schritt mit der Aktivierung der Oberfläche des Substrates (8) erfolgen.

Die Reinigungs-/Aktivierungskammer (3) wird zunächst auf den Prozessdruck < 5*10⁻⁵ mbar evakuiert und das Substrat (8) wird auf eine Temperatur bis ca. 700 °C erwärmt. Da das Substrat (8) direkt nach dem letzten Heißschritt der Keramisierung zur Beschichtung überführt wurde, ist die Aufheizung auf diese hohen Temperaturen mit einem weitaus geringeren Aufwand möglich, als bei den bekannten Verfahren.

In der Reinigungs-/Aktivierungskammer (3) werden nun zur Reinigung und Aktivierung Argon-Ionen mit einer Energie von ca. 400 eV auf die Oberfläche des Substrates (8) geschossen. Das Substrat (8) bewegt sich dabei kontinuierlich vorwärts mit einer Geschwindigkeit von ca. 3 cm/min. Anschließend wird das Substrat (8) in die Beschichtungskammer (4.1) überführt.

### Beschichtung:

Die erste Beschichtungskammer (4.1) ist ebenfalls eine Vakuumkammer und dient der Beschichtung mit einem ersten Ausgangsmaterial. Soll die Beschichtung mehrere Schichten aus unterschiedlichen Ausgangsmaterialien umfassen oder soll die Beschichtung mehrerer Substrate (8) parallel verlaufen, können auch weitere Beschichtungskammern (4.n) folgen.

In der ersten Beschichtungskammer (4.1) und in den eventuell erforderlichen weiteren Beschichtungskammern (4.n) befindet sich jeweils ein Target (14) mit dem Schichtausgangsmaterial, Heizelemente (9), Blenden (10), Ionenstrahl-Anregungsquelle (13) und eine unterstützende Ionenstrahlquelle (12).

Mit den Heizelementen (9) wird das Substrat (8) auf der gewünschten Prozesstemperatur gehalten. Das Schichtausgangsmaterial ist metallisches Zirkon-Yttrium in einem Verhältnis 92:8, welches mit einem Gemisch aus Xenon- und Argon-Ionen aus der Ionenstrahl-Anregungsquelle (13) mit einer Ionenenergie von 1500 eV beschossen wird. Gleichzeitig wird über das Prozessgas-Einlassventil (15) Sauerstoff zugeführt, so dass sich ein Zirkon-Yttrium-Oxid-Film auf dem Substrat (8) bildet. Die Blenden (10) definieren dabei ein Beschichtungsfenster über die gesamte Länge (senkrecht zur Substratbewegungsrichtung) des Substrates (8) mit einer Breite von 20 cm.

Zusätzlich wird aus der unterstützenden Ionenstrahlquelle (12) das Substrat (8) mit Argon-Ionen mit einer Ionenenergie von 100 eV beschossen. Das Substrat (8) wird nun durch geeignete Bewegungen über dem Beschichtungsfenster homogen mit einer Schichtdicke von 2 µm beschichtet. Nach der Beschichtung wird das Substrat (8) in die Nachbehandlungskammer (5) überführt.

### Nachbehandlung:

Die Nachbehandlungskammer (5) ist eine Vakuumkammer mit Heizelementen (9) und einem Sauerstoff-Zufuhrventil (16).

Das Substrat (8) wird auf Temperaturen > 400°C erhitzt und in der Kammer wird ein erhöhter Sauerstoffpartialdruck von > 10⁻² mbar eingestellt, um eine vollständige Oxidation der Schicht zu gewährleisten.

Prinzipiell ist es auch möglich, diese Nachbehandlung außerhalb der Beschichtungsanlage durchzuführen. Nach der Nachbehandlung wird das Substrat (8) in die Ausgangsschleuse (6.1) übergeben, welche dann auf Atmosphärendruck belüftet wird. Über die Substratabgabestation (6.2) verlässt das fertig beschichtete Sustrat (8) die Beschichtungsanlage.

Die so erhaltene beschichtete Kochfläche aus CERAN hat eine wesentlich erhöhte Kratzfestigkeit gegenüber einer unbeschichteten Kochfläche. Die Beschichtung ist widerstandsfähig gegenüber mechanischen Belastungen, strukturstabil bei Temperaturbelastungen bis 800°C und hat ein ansprechendes optisches Design.

## Patentansprüche

1. Glaskeramik-Kochfeld mit einer Schutzschicht, die mindestens eine Hartstoffschicht umfasst, die eine morphologisch dichte, im wesentlichen senkrecht zur Körperoberfläche aufwachsende Kolumnenstruktur aufweist und Zirkonoxid in einer temperaturstabilen Kristallphase umfasst.

2. Glaskeramik-Kochfeld nach Anspruch 1, **dadurch gekennzeichnet, dass** die dichte Kolumnenstruktur der Hartstoffschicht zu mindestens 50 %, vorzugsweise zu mehr als 80 % kristallin ist.

3. Glaskeramik-Kochfeld nach Anspruch 1 oder 2, **dadurch gekennzeichnet, dass** die Kolumnen im Mittel eine laterale Ausdehnung von kleiner 1µm und bevorzugt von kleiner 200 nm besitzen.

4. Glaskeramik-Kochfeld nach einem der Ansprüche 1 bis 3, **dadurch gekennzeichnet, dass** die Schichtdicke der Hartstoffschicht im Bereich von 100 bis 20000 nm, bevorzugt zwischen 500 bis 10000 nm und besonders bevorzugt zwischen 1500 bis 5000 nm liegt.

5. Glaskeramik-Kochfeld nach einem der Ansprüche 1 bis 4, **dadurch gekennzeichnet, dass** die Rauhigkeit der Oberfläche einen Rₐ-Wert < 50 nm, bevorzugt einen Rₐ-Wert < 30 nm und besonders bevorzugt einen Rₐ-Wert < 20 nm aufweist.

6. Glaskeramik-Kochfeld nach einem der Ansprüche 2 bis 5, **dadurch gekennzeichnet, dass** die eine dichte kristalline Kolumnenstruktur aufweisende Hartstoffschicht Siliziumnitrid umfasst.

7. Glaskeramik-Kochfeld nach einem der vorstehenden Ansprüche, **dadurch gekennzeichnet, dass** dem Zirkonoxid zur Stabilisierung der temperaturstabilen Kristallphase mindestens eine weitere Komponente zu gemischt ist.

8. Glaskeramik-Kochfeld nach Anspruch 7, **dadurch gekennzeichnet, dass** die stabilisierende Komponente mindestens ein Oxid aus der Gruppe Yttriumoxid, Calciumoxid, Magnesiumoxid, Tantaloxid, Nioboxid, Scandiumoxid, Titanoxid oder aus der Gruppe der Lanthanoid-Oxide, wie z.B. Lanthanoxid oder Ceriumoxid umfasst.

9. Glaskeramik-Kochfeld nach einem der vorstehenden Ansprüche, **dadurch gekennzeichnet, dass** die Zirkonoxid umfassende Hartstoffschicht zusätzlich die Komponente Hafniumoxid enthält.

10. Glaskeramik-Kochfeld nach Anspruch 8 oder 9, **dadurch gekennzeichnet, dass** die Zirkonoxid umfassende Hartstoffschicht als stabilisierende Komponente 0,5 bis 50 mol% Y₂O₃, vorzugsweise 1 bis 10 mol% Y₂O₃ und besonders bevorzugt 1,0 bis 7,5 mol% Y₂O₃ enthält.

11. Glaskeramik-Kochfeld nach Anspruch 10, **dadurch gekennzeichnet, dass** die Zirkonoxid umfassende Hartstoffschicht als stabilisierende Komponente 4 mol% (± 1 mol%) Y₂O₃ enthält.

12. Glaskeramik-Kochfeld nach einem der vorstehenden Ansprüche, **dadurch gekennzeichnet, dass** diese eine weitere Hartstoffschicht, insbesondere transparente Hartstoffschicht aufweist.

13. Glaskeramik-Kochfeld nach Anspruch 12, **dadurch gekennzeichnet, dass** die weitere Hartstoffschicht zu mindestens 50% aus Siliziumoxid besteht.

14. Glaskeramik-Kochfeld gemäß einem der vorstehenden Ansprüche, **dadurch gekennzeichnet, dass** die Hartstoffschicht lateral eng zusammenhängende, senkrecht zur Körperoberfläche aufwachsende kristalline Kolumnen aufweist, deren laterale Ausdehnung im Mittel weniger als 1 µm, bevorzugt weniger als 200 nm beträgt und die vorrangig Orientierungen von Kristallen aufweist, die bei kolumnaren Wachstum geringe Tendenzen zur Verbreiterung zeigen, wobei die Oberflächenrauhigkeit der Hartstoffschicht einen Rₐ-Wert < 50 nm, bevorzugt einen Rₐ-Wert < 20 nm aufweist.

15. Verfahren zum Herstellen eines Glaskeramik-Kochfelds mit einer Schutzschicht gemäss Ansprüche 1-14, mit den Schritten:
a) Bereitstellen der Glaskeramik-Kochplatte und der Schichtstoffe in einem Vakuumsystem,
b) Beschichten der Glaskeramik-Kochplatte mittels eines reaktiven
physikalischen Aufdampfprozesses, wobei Schichtstoffe in atomaren Abmessungen erzeugt werden,
**dadurch gekennzeichnet, dass**
b1) während des reaktiven physikalischen Aufdampfprozesses die in atomaren Abmessungen erzeugten Schichtstoffe zusätzlich energetisch angereichert werden, so dass sich morphologisch dichte Kolumnenstrukturen beim Aufwuchs der Schicht bilden, wobei die zusätzliche energetische Anreicherung durch einen unterstützenden Ionenstrahl erfolgt, der auf das Substrat gerichtet ist und wobei durch gezielte Einstellung der Intensität des Ionenstrahls und Wahl der Energie der Ionen die in atomaren Abmessungen erzeugten Atome der Schichtstoffe in morphologisch dichten Kolumnenstrukturen aufwachsen.

16. Verfahren gemäß Anspruch 15,
**dadurch gekennzeichnet, dass**
a1) die zu beschichtende Glaskeramik-Kochplatte unmittelbar nach ihrer Herstellung in das Vakuumsystem
zur Beschichtung überführt wird.

17. Verfahren nach Anspruch 15 oder 16, **dadurch gekennzeichnet, dass** die Beschichtung der Glaskeramik-Kochplatte mit Magnetronsputtern erfolgt.

18. Verfahren nach Anspruch 15 oder 16, **dadurch gekennzeichnet, dass** die Beschichtung der Glaskeramik-Kochplatte mit Ionenstrahlsputtern erfolgt.

19. Verfahren nach einem der vorstehenden Ansprüche, **dadurch gekennzeichnet, dass** die Energie der Ionen des unterstützenden Ionenstrahls zwischen 1 bis 2500 eV, bevorzugt zwischen 1 bis 800 eV, und besonders bevorzugt zwischen 20 bis 450 eV liegt.

20. Verfahren nach einem der vorstehenden Ansprüche, **dadurch gekennzeichnet, dass** eine zusätzliche Ionenquelle die Ionen des unterstützenden Ionenstrahls bereitstellt.

21. A Verfahren nach einem der Ansprüche 15 bis 19, **dadurch gekennzeichnet, dass** die Ionen des unterstützenden Ionenstrahls dem am Sputterprozess beteiligten Plasma entzogen werden.

22. Verfahren nach einem der Ansprüche 15 bis 21, **dadurch gekennzeichnet, dass** die Schichtstoffe in fester Form als metallische Komponenten oder als Metalloxide vorliegen.

23. Verfahren nach Anspruch 22, **dadurch gekennzeichnet, dass** zusätzlich während des Aufdampfprozesses Sauerstoff in das Vakuumsystem eingespeist wird.

24. Verfahren nach Anspruch 22 oder 23, **dadurch gekennzeichnet, dass** mindestens ein zusätzliches Gas, vorzugsweise Stickstoff, zur Optimierung der Abtragsrate bei der Erzeugung der Schichtstoffe und zur Optimierung der Entstehung von atomaren Sauerstoff, in das Vakuumsystem eingespeist wird.

25. Verfahren nach einem der vorstehenden Ansprüche, **dadurch gekennzeichnet, dass** die Beschichtung der Glaskeramik-Kochplatte eine Temperaturnachbehandlung, vorzugsweise in einer Sauerstoffatmosphäre, zur Optimierung der Kristallstruktur und des Sauerstoffgehaltes der aufgebrachten Schichtstoffe umfasst.

26. Verfahren nach Anspruch 25, **dadurch gekennzeichnet, dass** die Temperaturnachbehandlung bei Temperaturen bis 800°C, vorzugsweise bei Temperaturen zwischen 400°C bis 700°C erfolgt.

27. Verfahren nach einem der Ansprüche 15, 17 bis 27, **dadurch gekennzeichnet, dass** die Oberfläche des zu beschichtenden Körpers vor seiner Beschichtung einer Reinigung unterzogen wird.

28. Verfahren nach Ansprüche 27, **dadurch gekennzeichnet, dass** die Reinigung in einer Vakuumkammer durch eine Plasmabehandlung mit Ionen erfolgt, deren Energie vorzugsweise im Bereich von 1 bis 2500 eV, bevorzugt von 50 bis 1600 eV, und besonders bevorzugt von 100 bis 500 eV liegt.

29. Verfahren nach einem der Ansprüche 15 bis 28, **dadurch gekennzeichnet, dass** die Oberfläche des zu beschichtenden Körpers vor seiner Beschichtung aktiviert wird.

30. Verfahren nach Anspruch 29, **dadurch gekennzeichnet, dass** die Aktivierung in einer Vakuumkammer durch eine Plasmabehandlung mit Ionen erfolgt, deren Energie vorzugsweise im Bereich von 1 bis 2500 eV, bevorzugt von 50 bis 1600 eV, und besonders bevorzugt von 100 bis 500 eV liegt.

31. Verfahren nach Anspruch 28 und 30, **dadurch gekennzeichnet, dass** die Reinigung und Aktivierung in einem Prozessschritt erfolgen.

32. Verfahren nach einem der Ansprüche 15 bis 31, **dadurch gekennzeichnet, dass** der zu beschichtende Körper zumindest vor dem Abscheiden der Schichtstoffe auf Prozesstemperaturen bis 800° C erwärmt wird, die bevorzugt zwischen 50° C und 550° C und besonders bevorzugt zwischen 100° C und 350° C liegen.

33. Verfahren nach einem der Ansprüche 15 bis 32, **dadurch gekennzeichnet, dass** die Beschichtung das Polieren der Oberfläche der aufgebrachten Schicht in mindestens einem Polierschritt umfasst.

34. Verwendung einer Anordnung zum Beschichten eines Körpers aus Glas, Glaskeramik oder einem anderen nichtmetallischen kristallinen Material,
umfassend eine Beschichtungsanlage, die mindestens eine Beschichtungskammer (4.1) aufweist, wobei
die Beschichtungskammer (4.1) eine Vakuumkammer ist und die Beschichtungskammer (4.1) ein Target (14) mit dem Schichtausgangsmaterial, eine Anregungsquelle zur Erzeugung von Schichtausgangsmaterialien in atomaren Abmessungen, eine auf das Substrat (8) gerichtete, unterstützende Ionenstrahlquelle (12), mindestens ein Prozessgas-Einlassventil (15) zur Zufuhr von Prozessgasen in die Beschichtungskammer (4.1) sowie Shutter (7) zur Zu- und Abfuhr des zu beschichtenden Substrates (8) in die Beschichtungskammer (4.1) aufweist,
wobei,
die Beschichtungsanlage über eine Substratübergabestation (2.1) und eine Eingangsschleuse (2.2) direkt mit der Herstellungsanlage (1) des zu beschichtenden Substrates (8) verbunden ist zum Beschichten einer Glaskeramik-Kochplatte mit einer Schutzschicht gemäß den Ansprüchen 1 bis 14.

35. Verwendung nach Anspruch 34, **dadurch gekennzeichnet, dass** die Anregungsquelle eine Ionenstrahl-Anregungsquelle (13) ist.

36. Verwendung nach Anspruch 34, **dadurch gekennzeichnet, dass** die Anregungsquelle eine Magnetronsputterquelle ist.

37. Verwendung nach einem der Ansprüche 34 bis 36, **dadurch gekennzeichnet, dass** die Beschichtungsanlage eine Reinigungs-/Aktivierungskammer (3) aufweist, wobei die Reinigungs-/Aktivierungskammer (3) eine Vakuumkammer ist und mindestens eine Reinigungs-/Aktivierungs-Ionenstrahlquelle (11) zur Reinigung und/oder Aktivierung des Substrates (8) aufweist, zwischen der Eingangsschleuse (2.2) und der Beschichtungskammer (4.1) angeordnet ist und über Shutter (7) mit diesen verbunden ist.

38. Verwendung nach einem der Ansprüche 34 bis 37, **dadurch gekennzeichnet, dass** die Beschichtungsanlage weitere Beschichtungskammern (4.n), mit n > 1 aufweist.

39. Verwendung nach einem der Ansprüche 34 bis 38, **dadurch gekennzeichnet, dass** die Beschichtungsanlage eine Nachbehandlungskammer (5) aufweist, wobei die Nachbehandlungskammer (5) eine Vakuumkammer ist und mindestens ein Sauerstoff-Zufuhrventil (16) sowie Heizelemente (9) enthält und über einen Shutter (7) mit der Beschichtungskammer (4.1) bzw. einer weiteren Beschichtungskammer (4.n) verbunden ist.

40. Verwendung nach einem der Ansprüche 34 bis 39, **dadurch gekennzeichnet, dass** die Beschichtungskammer (4.1) bzw. die weiteren Beschichtungskammern (4.n) und die Reinigungs-/Aktivierungskammer (3) Heizelemente (9) zur Einstellung der Beschichtungstemperatur aufweisen.

## Claims

1. Glass ceramic hob with a protective coating which includes at least one hard material layer which comprises a morphologically dense column structure growing substantially perpendicular to the body surface and comprises zirconium oxide in a temperature-stable crystal phase.

2. Glass ceramic hob according to claim 1, **characterised in that** the dense column structure of the hard material layer is at least 50%, preferably more than 80% crystalline.

3. Glass ceramic hob according to claim 1 or 2, **characterised in that** the columns on average have a lateral expansion of less than 1 µm and preferably less than 200 nm.

4. Glass ceramic hob according to one of the claims 1 to 3, **characterised in that** the layer thickness of the hard material layer lies in the range from 100 to 20000 nm, preferably between 500 and 10000 nm and particularly preferably between 1500 and 5000 nm.

5. Glass ceramic hob according to one of the claims 1 to 4, **characterised in that** the roughness of the surface has a Rₐ value < 50 nm, preferably a Rₐ value < 30 nm and particularly preferably a Rₐ value < 20 nm.

6. Glass ceramic hob according to one of the claims 2 to 5, **characterised in that** the hard material layer having a dense crystalline column structure comprises silicon nitride.

7. Glass ceramic hob according to one of the preceding claims, **characterised in that** at least one further component is mixed with the zirconium oxide in order to stabilise the temperature-stable crystal phase.

8. Glass ceramic hob according to claim 7, **characterised in that** the stabilising component includes at least one oxide from the group yttrium oxide, calcium oxide, magnesium oxide, tantalum oxide, niobium oxide, scandium oxide, titanium oxide or from the group of lanthanoid oxides, e.g. lanthanium oxide or cerium oxide.

9. Glass ceramic hob according to one of the preceding claims, **characterised in that** the hard material layer comprising the zirconium oxide additionally contains the component hafnium oxide.

10. Glass ceramic hob according to claim 8 or 9, **characterised in that** the hard material layer including the zirconium oxide contains, as a stabilising component, 0.5 to 50 mol.% Y₂O₃, preferably 1 to 10 mol.% Y₂O₃ and particularly preferably 1.0 to 7.5 mol.% Y₂O₃.

11. Glass ceramic hob according to claim 10, **characterised in that** the hard material layer comprising the zirconium oxide contains 4 mol.% (+- 1 mol.%) Y₂O₃.

12. Glass ceramic hob according to one of the preceding claims, **characterised in that** it comprises a further hard material layer, in particular a transparent hard material layer.

13. Glass ceramic hob according to claim 12, **characterised in that** the further hard material layer consists of at least 50% silicon oxide.

14. Glass ceramic hob according to one of the preceding claims, **characterised in that** the hard material layer comprises crystalline columns growing perpendicular to the body surface and laterally closely connected, of which the lateral expansion on average is less than 1 µm, preferably less than 200 nm and which, as a priority, has orientations of crystals which show lower tendencies to spread with column growth, whereby the surface roughness of the hard material layer has a Rₐ value < 50 nm, preferably a Rₐ value < 20 nm.

15. Method for producing a glass ceramic hob with a protective layer according to claims 1 to 14, with the steps:
a) Provision of the glass ceramic hotplate and the layer materials in a vacuum system,
b) Coating of the glass ceramic hotplate by means of a reactive physical vapour deposition process, whereby layer materials are produced in atomic dimensions, **characterised in that**
b1) during the reactive physical vapour deposition process, the layer materials produced in atomic dimensions are additionally energetically enriched, so that morphologically dense column structures form during the growth of the layer, whereby the additional energetic enrichment takes place through a supporting ion beam which is orientated to the substrate and whereby through the targeted setting of the intensity of the ion beam and choice of the energy of the ions, the atoms of the layer materials produced in atomic dimensions grow in morphologically dense column structures.

16. Method according to claim 15, **characterised in that**
a1) the glass ceramic hotplate to be coated is conveyed directly after its production into the vacuum system for coating.

17. Method according to claim 15 or 16, **characterised in that** the coating of the glass ceramic hotplate takes place with magnetron sputtering.

18. Method according to claim 15 or 16, **characterised in that** the coating of the glass ceramic hotplate takes place with ion beam sputtering.

19. Method according to one of the preceding claims, **characterised in that** the energy of the ions of the supporting ion beam lies between 1 to 2500 eV, preferably between 1 to 800 eV, and particularly preferably between 20 to 450 eV.

20. Method according to one of the preceding claims, **characterised in that** an additional ion source provides the ions of the supporting ion beam.

21. Method according to one of the claims 15 to 19, **characterised in that** the ions of the supporting ion beam are removed from the plasma involved in the sputtering process.

22. Method according to one of the claims 15 to 21, **characterised in that** the layer materials exist in solid form as metal components or as metal oxides.

23. Method according to claim 22, **characterised in that** oxygen is additionally fed into the vacuum system during the vapour deposition process.

24. Method according to claim 22 or 23, **characterised in that** at least one additional gas, preferably nitrogen, is fed into the vacuum system in order to optimise the ablation rate during the production of the layer materials and in order to optimise the production of atomic oxygen.

25. Method according to one of the preceding claims, **characterised in that** the coating of the glass ceramic hotplate includes a temperature aftertreatment, preferably in an oxygen atmosphere, for optimisation of the crystal structure and of the oxygen content of the applied layer materials.

26. Method according to claim 25, **characterised in that** the temperature aftertreatment takes place at temperatures up to 800°C, preferably at temperatures between 400°C to 700°C.

27. Method according to one of the claims 15 to 17, **characterised in that** the surface of the body to be coated is subjected to purification before being coated.

28. Method according to claim 27, **characterised in that** the purification is realised in a vacuum chamber by a plasma treatment with ions, of which the energy lies preferably in the range from 1 to 2500 eV, more preferably 50 to 1600 eV, and particularly preferably 100 to 500 eV.

29. Method according to one of the claims 15 to 28, **characterised in that** the surface of the body to be coated is activated before being coated.

30. Method according to claim 29, **characterised in that** the activation is realised in a vacuum chamber by a plasma treatment with ions, of which the energy is preferably in the range from 1 to 2500 eV, more preferably 50 to 1600 eV and particularly preferably 100 to 500 eV.

31. Method according to claims 28 and 30, **characterised in that** the purification and activation takes place in one process step.

32. Method according to one of the claims 15 to 31, **characterised in that** the body to be coated is heated at least before the separation of the layer materials to process temperatures up to 800°C, which preferably lie between 50 and 550°C and particularly preferably between 100°C and 350°C.

33. Method according to one of the claims 15 to 32, **characterised in that** the coating includes the polishing of the surface of the applied layer in at least one polishing stage.

34. Use of an arrangement for coating a body of glass, glass ceramic or another non-metallic crystalline material, comprising a coating installation which comprises at least one coating chamber (4.1), whereby the coating chamber (4.1) is a vacuum chamber and the coating chamber (4.1) comprises a target (14) with the layer starting material, an excitation source for generating layer starting material in atomic dimensions, a supporting ion beam source orientated to the substrate (8), at least one process gas inlet valve (15) for the supply of process gases into the coating chamber (4.1) and shutters (7) for supply and removal of the substrate to be coated into / from the coating chamber (4.1),
whereby
the coating installation is connected via a substrate transfer station (2.1) and an inlet sluice element (2.2) directly to the production installation (1) of the substrate (8) to be coated, for the coating of a glass ceramic hotplate with a protective layer according to claims 1 to 14.

35. Use according to claim 34, **characterised in that** the excitation source is an ion beam excitation source (13).

36. Use according to claim 34, **characterised in that** the excitation source is a magnetron sputtering source.

37. Use according to one of the claims 34 to 36, **characterised in that** the coating installation comprises a purification / activation chamber (3), whereby the purification / activation chamber (3) is a vacuum chamber and comprises at least one purification / activation ion beam source (11) for purifying and / or activating the substrate (8), is arranged between the inlet sluice element (2.2) and the coating chamber (4.1) and is connected thereto by means of shutters (7).

38. Use according to one of the claims 34 to 37, **characterised in that** the coating system comprises further coating chambers (4.n), with n > 1.

39. Use according to one of the claims 34 to 39, **characterised in that** the coating installation comprises an aftertreatment chamber (5), whereby the aftertreatment chamber (5) is a vacuum chamber and contains at least one oxygen supply valve (16) and heating elements (9) and is connected by means of a shutter (7) to the coating chamber (4.1) or a further coating chamber (4.n).

40. Use according to one of the claims 34 to 39, **characterised in that** the coating chamber (4.1) and the further coating chambers (4.n) and the purification /activation chamber (3) comprise heating elements (9) for setting the coating temperature.

## Revendications

1. Table de cuisson en vitrocéramique pourvue d'une couche protectrice, qui comprend au moins une couche en matériau mécaniquement très résistant, présente une structure en colonnes morphologiquement dense, se développant pour l'essentiel perpendiculairement à la surface du corps et comprend de l'oxyde de zirconium en une phase cristalline thermostable.

2. Table de cuisson en vitrocéramique suivant la revendication 1, **caractérisée en ce que** la structure dense en colonnes de la couche en matériau mécaniquement très résistant est cristalline à 50 % au moins, avantageusement à plus de 80 %.

3. Table de cuisson en vitrocéramique suivant la revendication 1 ou 2, **caractérisée en ce que** les colonnes possèdent en moyenne une extension latérale de moins de 1 µm et préférentiellement de moins de 200 nm.

4. Table de cuisson en vitrocéramique suivant l'une des revendications 1 à 3, **caractérisée en ce que** l'épaisseur de la couche de matériau mécaniquement très résistant se situe dans une plage de 100 à 20 000 nm, avantageusement entre 500 et 10 000 nm et très avantageusement entre 1500 et 5000 nm.

5. Table de cuisson en vitrocéramique suivant l'une des revendications 1 à 4, **caractérisée en ce que** la rugosité de la surface a une valeur Rₐ inférieure à 50 nm, avantageusement une valeur Rₐ inférieure à 30 nm et très avantageusement une valeur Rₐ inférieure à 20 nm.

6. Table de cuisson en vitrocéramique suivant l'une des revendications 2 à 5, **caractérisée en ce que** la couche de matériau mécaniquement très résistant possédant une structure cristalline dense en colonnes comprend du nitrure de silicium.

7. Table de cuisson en vitrocéramique suivant l'une des revendications précédentes, **caractérisée en ce qu'**au moins un autre composant est ajouté à l'oxyde de zirconium en vue de stabiliser la phase cristalline thermostable.

8. Table de cuisson en vitrocéramique suivant la revendication 7, **caractérisée en ce que** le composant stabilisant comprend au moins un oxyde du groupe formé de l'oxyde d'yttrium, l'oxyde de calcium, l'oxyde de magnésium, l'oxyde de tantale, l'oxyde de niobium, l'oxyde de scandium, l'oxyde de titane, ou du groupe formé des oxydes des lanthanides tels que, par exemple, l'oxyde de lanthane ou l'oxyde de cérium.

9. Table de cuisson en vitrocéramique suivant l'une des revendications précédentes, **caractérisée en ce que** la couche de matériau mécaniquement très résistant comprenant l'oxyde de zirconium contient, comme autre composant, de l'oxyde de hafnium.

10. Table de cuisson en vitrocéramique suivant la revendication 8 ou 9, **caractérisée en ce que** la couche de matériau mécaniquement très résistant comprenant de l'oxyde de zirconium contient comme composant stabilisant 0,5 à 50 mol % de Y₂O₃, avantageusement 1 à 10 mol % de Y₂O₃ et très avantageusement 1,0 à 7,5 mol % de Y₂O₃.

11. Table de cuisson en vitrocéramique suivant la revendication 10, **caractérisée en ce que** la couche de matériau mécaniquement très résistant comprenant de l'oxyde de zirconium contient comme composant stabilisant 4 mol % (± 1 mol %) de Y₂O₃.

12. Table de cuisson en vitrocéramique suivant l'une des revendications précédentes, **caractérisée en ce qu'**elle présente une autre couche de matériau mécaniquement très résistant, en particulier une couche transparente de matériau mécaniquement très résistant.

13. Table de cuisson en vitrocéramique suivant la revendication 12, **caractérisée en ce que** l'autre couche de matériau mécaniquement très résistant est constituée au moins à 50 % d'oxyde de silicium.

14. Table de cuisson en vitrocéramique suivant l'une des revendications précédentes, **caractérisée en ce que** la couche de matériau mécaniquement très résistant présente des colonnes cristallines latéralement contiguës, se développant perpendiculairement à la surface du corps, dont l'extension latérale est en moyenne inférieure à 1 µm, avantageusement inférieure à 200 nm et qui présente prioritairement des orientations de cristaux qui montrent dans la croissance en colonnes de faibles tendances à l'élargissement, la rugosité de surface de la couche de matériau mécaniquement très résistant présentant une valeur Rₐ inférieure à 50 nm, avantageusement une valeur Rₐ inférieure à 20 nm.

15. Procédé de fabrication d'une table de cuisson en vitrocéramique pourvue d'une couche protectrice selon les revendications 1-14, comprenant les étapes suivantes :
a) mise en place de la plaque de cuisson en vitrocéramique et des matériaux de revêtement dans un système à vide,
b) revêtement de la plaque de cuisson en vitrocéramique par un processus physique de vaporisation réactive dans lequel des matériaux de revêtement sont générés en dimensions atomiques, **caractérisé en ce que**
b1) pendant le processus physique de vaporisation réactive, les matériaux de revêtement générés en dimensions atomiques sont en outre enrichis en énergie, de sorte qu'il se forme, lors de l'accroissement de la couche, des structures en colonnes morphologiquement denses, l'enrichissement énergétique additionnel étant produit par un faisceau ionique d'assistance qui est dirigé sur le substrat et, sous l'effet d'un réglage adéquat de l'intensité du faisceau ionique et par le choix de l'énergie des ions, les atomes des matériaux de revêtement générés en dimensions atomiques se développent en structures en colonnes morphologiquement denses.

16. Procédé suivant la revendication 15, **caractérisé en ce que**
a1) la plaque de cuisson en vitrocéramique à revêtir est transférée dans le système à vide en vue de son revêtement immédiatement après sa fabrication.

17. Procédé suivant la revendication 15 ou 16, **caractérisé en ce que** le revêtement de la plaque de cuisson en vitrocéramique est effectué par pulvérisation par magnétron.

18. Procédé suivant la revendication 15 ou 16, **caractérisé en ce que** le revêtement de la plaque de cuisson en vitrocéramique est effectué par pulvérisation par faisceau ionique.

19. Procédé suivant l'une des revendications précédentes, **caractérisé en ce que** l'énergie des ions du faisceau ionique d'assistance se situe entre 1 et 2500 eV, avantageusement entre 1 et 800 eV et très avantageusement entre 20 et 450 eV.

20. Procédé suivant l'une des revendications précédentes, **caractérisé en ce qu'**une source d'ions supplémentaire rend disponibles les ions du faisceau ionique d'assistance.

21. Procédé suivant l'une des revendications 15 à 19, **caractérisé en ce que** les ions du faisceau ionique d'assistance sont empruntés au plasma qui participe au processus de pulvérisation.

22. Procédé suivant l'une des revendications 15 à 21, **caractérisé en ce que** les matériaux de revêtement se présentent sous forme solide comme composants métalliques ou comme oxydes métalliques.

23. Procédé suivant la revendication 22, **caractérisé en ce que** de l'oxygène est en outre injecté dans le système à vide pendant le processus de vaporisation.

24. Procédé suivant la revendication 22 ou 23, **caractérisé en ce qu'**au moins un gaz supplémentaire, avantageusement de l'azote, est injecté dans le système à vide pour optimiser la vitesse d'enlèvement lorsque les matériaux de revêtement sont générés et pour optimiser la production d'oxygène atomique.

25. Procédé suivant l'une des revendications précédentes, **caractérisé en ce que** le revêtement de la plaque de cuisson en vitrocéramique implique un post-traitement thermique, avantageusement dans une atmosphère d'oxygène, pour optimiser la structure des cristaux et la teneur en oxygène des matériaux de revêtement appliqués.

26. Procédé suivant la revendication 25, **caractérisé en ce que** le post-traitement thermique est conduit à des températures allant jusqu'à 800°C, avantageusement à des températures comprises entre 400°C et 700°C.

27. Procédé suivant l'une des revendications 15, 17 à 27, **caractérisé en ce que** la surface du corps à revêtir est soumise à un nettoyage avant son revêtement.

28. Procédé suivant la revendication 27, **caractérisé en ce que** le nettoyage est effectué dans une chambre à vide par un traitement par plasma avec des ions dont l'énergie se situe avantageusement dans une plage de 1 à 2500 eV, préférentiellement de 50 à 1600 eV, et très préférentiellement de 100 à 500 eV.

29. Procédé suivant l'une des revendications 15 à 28, **caractérisé en ce que** la surface du corps à revêtir est activée avant son revêtement.

30. Procédé suivant la revendication 29, **caractérisé en ce que** l'activation est effectuée dans une chambre à vide par un traitement par plasma avec des ions dont l'énergie se situe avantageusement dans une plage de 1 à 2500 eV, préférentiellement de 50 à 1600 eV, et très préférentiellement de 100 à 500 eV.

31. Procédé suivant les revendications 28 et 30, **caractérisé en ce que** le nettoyage et l'activation sont effectués en une seule et même étape.

32. Procédé suivant l'une des revendications 15 à 31, **caractérisé en ce que** le corps à revêtir est chauffé, tout au moins avant le dépôt des matériaux de revêtement, à des températures jusqu'à 800°, qui se situent avantageusement entre 50 et 550°C et très avantageusement entre 100 et 350°C.

33. Procédé suivant l'une des revendications 15 à 32, **caractérisé en ce que** le revêtement comprend le polissage en au moins une étape de la surface de la couche appliquée.

34. Utilisation d'un dispositif en vue du revêtement d'un corps en verre, en vitrocéramique ou en un autre matériau cristallin non métallique, comprenant une installation de revêtement qui comporte au moins une chambre de revêtement (4.1), la chambre de revêtement (4.1) étant une chambre à vide et la chambre de revêtement (4.1) présentant une cible (14) pourvue de la matière de départ pour le revêtement, une source d'excitation destinée à produire des matériaux de départ de revêtement en dimensions atomiques, une source (12) de faisceau ionique d'assistance dirigée sur le substrat (8), au moins une soupape (15) d'admission de gaz de traitement servant à faire arriver des gaz de traitement dans la chambre de revêtement (4.1) ainsi qu'un volet (7) servant à faire arriver le substrat (8) à revêtir à la chambre de revêtement (4.1) et à l'en retirer, l'installation de revêtement communiquant directement avec l'installation de fabrication (1) du substrat (8) à revêtir par l'intermédiaire d'un poste (2.1) de transfert du substrat et d'un sas d'entrée (2.2), pour revêtir une plaque de cuisson en vitrocéramique d'une couche de protection suivant les revendications 1 à 14.

35. Utilisation suivant la revendication 34, **caractérisée en ce que** la source d'excitation est une source d'excitation (13) à faisceau ionique.

36. Utilisation suivant la revendication 34, **caractérisée en ce que** la source d'excitation est une source de pulvérisation à magnétron.

37. Utilisation suivant l'une des revendications 34 à 36, **caractérisée en ce que** l'installation de revêtement comprend une chambre de nettoyage/activation (3), la chambre de nettoyage/activation (3) étant une chambre à vide comportant au moins une source (11) à faisceau ionique de nettoyage/activation destinée au nettoyage et/ou à l'activation du substrat (8), étant disposée entre le sas d'entrée (2.2) et la chambre de revêtement (4.1) et communiquant avec cette dernière par le volet (7).

38. Utilisation suivant l'une des revendications 34 à 37, **caractérisée en ce que** l'installation de revêtement comporte d'autres chambres de revêtement (4.n), avec n > 1.

39. Utilisation suivant l'une des revendications 34 à 38, **caractérisée en ce que** l'installation de revêtement comprend une chambre de post-traitement (5), la chambre de post-traitement (5) étant une chambre à vide et contenant au moins une soupape (16) d'amenée d'oxygène ainsi que des éléments chauffants (9) et communiquant par un volet (7) avec la chambre de revêtement (4.1) ou avec une autre chambre de revêtement (4.n).

40. Utilisation suivant l'une des revendications 34 à 39, **caractérisée en ce que** la chambre de revêtement (4.1) ou les autres chambres de revêtement (4.n) et la chambre de nettoyage/activation (3) comportent des éléments chauffants (9) servant au réglage de la température de revêtement.
